# EUROPEAN PATENT SPECIFICATION

(11) **EP 3 113 592 B1**
(45) Date of publication and mention of the grant of the patent: **01.05.2019**
(21) Application number: 16176116.8
(22) Date of filing: 24.06.2016
(51) Int. Cl.: H05K 7/20

(54) **CABINET AIR-CONDITIONING GUIDING MECHANISM**
SCHRANK-KLIMATISIERUNGSFÜHRUNGSMECHANISMUS
MÉCANISME DE GUIDAGE DE CLIMATISATION D'ARMOIRE

(30) Priority: 03.07.2015 TW 104121584
(43) Date of publication of application: 04.01.2017
(73) Proprietor: Tseng, Ching-Chao, Changhua County 509 (TW)
(72) Inventor: Tseng, Ching-Chao, Changhua County 509 (TW)
(74) Representative: Lang, Christian

(56) References cited:
- WO-A1-2005/104642
- WO-A1-2008/014578
- WO-A1-2010/054786
- WO-A2-03/005791
- CN-A- 102 917 559
- CN-A- 103 777 703
- CN-U- 204 145 972
- TW-U- M 510 433
- US-A1- 2001 029 163
- US-A1- 2003 147 216
- US-A1- 2010 078 157
- US-A1- 2014 187 137

## Description

### BACKGROUND OF THE INVENTION

### 1. Field of the Invention

The present invention relates to an air-conditioning management system applied to a cabinet or an electronic equipment room and, more particularly, to a cabinet air-conditioning guiding mechanism for directing air into the cabinet.

### 2. Description of Related Art

Recently, for the air-conditioning management of an electronic equipment room, the whole space of the electronic equipment room is mostly applied to a unity plan. In this way, it is not only costly, but also needs a lot of space to arrange rows of cabinets and reserve enough space for setting cold/hot aisles between cabinets, so it is very space-consuming. Furthermore, air conditioning is cycled in the whole space of the electronic equipment room, so it may waste a lot of energy.

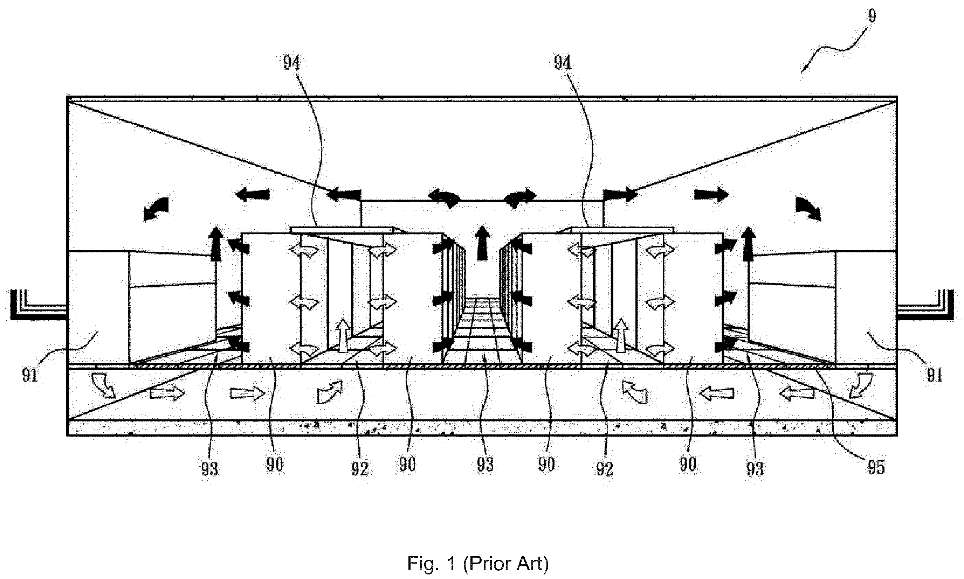

As shown in FIG. 1, which is a conventional air-conditioning plan of an electronic equipment room 9, there are four rows of cabinets 90, each row of cabinets 90 are corresponded to another row with face-to-back configuration, and enough spacing is reserved between rows, so as to plan the face-to-face spacing as cold channels 92 and the back-to-back spacing as hot channels 93. Cold air is guided into the cold channels by using cooling apparatus 91 on two sides, so as to let cold air flow into the cabinets 90 from face of the cabinets 90 (shown as white arrows in FIG. 1, which show the flow of cold air) for heat exchange with the electronic equipments set in the cabinets 90. At last, hot air exhausted from back of the cabinets 90 is centralized in the hot channels 93 for recycling by the cooling apparatus 91 (shown as black arrows in FIG. 1, which show the flow of hot air) to regenerate into cold air to form a full air-conditioning recycle. In this kind of plan of the electronic equipment room 9, although the cold channels 92 are independently separated by elevated floor 95 and baffles 94 to prevent cold air from flowing out that wastes energy, a lot of space is needed to arrange the cabinets 90 and the setting of the elevated floor also costs a lot.

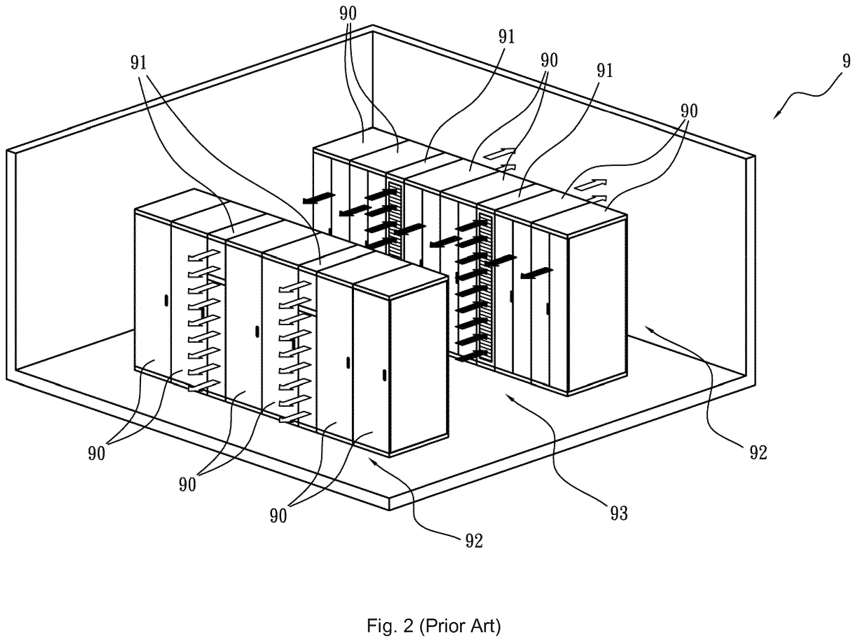

Also, as shown in FIG. 2, it is another conventional air-conditioning plan of an electronic equipment room 9, cooling apparatus 91 is setting between cabinets 90, so that hot air could be recycled from back of the cabinets 90 by the cooling apparatus 91, and cold air is directly supplied to cold channels 92 (as shown in FIG. 2, white arrows show direction of cold air, black arrows show direction of hot air). A lot of space is still needed to arrange the cabinets 90 in this kind of plan. Although cost of setting the elevated floor may be saved, the cold channels 92 and the hot channels 93 are open design, cold air supplied by the cooling apparatus 91 may consume in other space in the electronic equipment room 9, it not only wastes energy, but also reduces the efficiency of cabinet air-conditioning management.

International patent application publication WO 2010/054786 A1 discloses a cabinet air-conditioning method and sensor arrangement that serves to ensure a more accurate control of a circulated air flow to keep the amount of circulated air as low as possible for providing significant energy savings.

In view of difficulty and drawbacks of planning air-conditioning of an electronic equipment room, the inventor researches for improvement and the present invention is finally completed.

### SUMARRY OF THE INVENTION

The object of the present invention is to reduce needed space of air-conditioning in an electronic equipment room by using air-conditioning guide module, it is applicable to ordinary cabinets and the cost of planning the whole air-conditioning may be significantly reduced.

Another object of the present invention is to form an enclosed space by associating the cabinets with the air-conditioning guide module, air-conditioning is directly guided to the cabinets to achieve the best efficacy of cabinet air-conditioning and reduce wasted energy significantly.

To achieve the object, a cabinet air-conditioning guiding mechanism according to claim 1 is provided. Further embodiments are subject matter of the dependent claims.

The air-conditioning guide module of the present invention including a cabinet comprises a front frame and a rear frame with their shape matching the cabinet. The front frame and the rear frame are provided to respectively connect to a front side and a rear side of the cabinet, the front frame has a front space inside, the rear frame has a rear space inside, the front space and the rear space are communicated with a placing space inside the cabinet while the front frame and the rear frame are connected to the cabinet, so as to form an isolated space; and, at least a front guide module is set on the front frame for guiding outside cold air flowing inwards, a rear guide module is set on the rear frame for guiding hot air generated inside flowing outwards, an air-conditioning guide module is then composed to directly apply air-conditioning process for interior of the cabinet. By guiding cold air flowing inwards and hot air flowing outwards, energy may be effectively saved and the best air-conditioning process may be applied to equipments in the cabinet.

Preferred, the front guide module includes an inlet and a front air distribution unit, the rear guide module includes an outlet and a rear air distribution unit.

Preferred, wherein the front guide module may set on top or bottom of the front frame, the rear guide module may set on top of the rear frame.

Preferred, wherein a temperature sensing unit set in the rear frame is provided to control the front air distribution unit and the rear air distribution unit for adjusting the speed of guiding air according to the temperature sensed in the interior.

Furthermore, according to the above-mentioned air-conditioning guide module, a cooling apparatus may be applied in electronic equipment rooms with various specifications. If there are multiple cabinets, it is not difficult to plan space that the present invention could be directly applied to an ordinary electronic equipment room without planning air-conditioning again, thus the setting cost may be reduced. And, air-conditioning guide mechanism for the cabinet saves energy effectively and optimizes performance of heat exchange process for cabinets.

For this reason, the cabinet air-conditioning guiding mechanism of the present invention mainly includes at least a cabinet, at least an air-conditioning guiding module and a cooling mechanism. Wherein, a placing space set in the cabinet is provided to place electronic devices; the air-conditioning guide module is corresponded to the cabinet, which includes a front frame and a rear frame provided to respectively connect to a front side and a rear side of the cabinet, the front frame has a front space inside, the rear frame has a rear space inside, the front space and the rear space are communicated with a placing space inside the cabinet but enclosed to the outside while the front frame and the rear frame are connected to the cabinet; and, at least a front guide module is set on the front frame for guiding outside cold air flowing inwards, a rear guide module is set on the rear frame for guiding hot air generated inside flowing outwards, to form an unidirectional flow mechanism directly applied to the interior of the cabinet. The cooling mechanism includes a cold communicating pipeline, a hot communicating pipeline and a cooling apparatus. The cooling apparatus is provided to receive hot air and generate cold air. The cold communicating pipeline respectively connected to the front guide module and the cooling apparatus is provided to supply cold air generated by the cooling apparatus to the front frame. The hot communicating pipeline respectively connected to the rear guide module and the cooling apparatus is provided to supply hot air exhausted from the rear frame to the cooling apparatus.

In this way, the cold communicating pipeline and the hot communicating pipeline are used to guide air-conditioning for the cabinet, to effectively prevent cold air generated by the cooling apparatus from escaping to external environment for saving energy, and in this direct guiding method, heat exchange may be fully completed in the cabinet and an appropriate temperature may be maintained, so that the internal electronic equipments may have good performance.

Preferred, the front guide module includes an inlet and a front air distribution unit, the rear guide module includes an outlet and a rear air distribution unit.

Preferred, wherein a temperature sensing unit set in the rear frame is provided to control the front air distribution unit and the rear air distribution unit for adjusting the speed of guiding air according to the temperature sensed in the interior.

Preferred, wherein two front guide modules are set on the front guide module, which are placed on top and bottom of the front frame respectively, and the cooling mechanism includes two cold communicating pipelines, which are respectively connected the two front guide modules to the cooling apparatus from above or below corresponding positions.

Preferred, wherein multiple temperature sensing units are set in the rear frame and respectively located in the positions with different height, the corresponding front guide modules may be adjusted respectively according to the temperature sensed on different height in the rear frame.

Preferred, wherein the amount of the cabinets and the air-conditioning guide modules is correspondingly a multiple number, multiple connecting ends set on the cold communicating pipeline are provided to connect to the front guide module of each front frame and the cooling apparatus, multiple connecting ends set on the hot communicating pipeline are provided to connect to the rear guide module of each rear frame and the cooling apparatus.

Besides, in the cabinet air-conditioning guiding mechanism of the present invention, the front space of the front frame and the rear space of the rear frame may further be provided to set related accessories required by electronic equipments, such as a power distribution unit or a cabling management equipment. By making good use of the additional space, air flow could not be affected if it is too crowded in the cabinet, so that airflow could have good liquidity and the efficiency of cooling in the interior of the cabinet may be improved.

Preferred, multiple spaced power supply units are set on a side of the power distribution unit set in the front space or the rear space, and each power supply unit is correspondingly to a location reserved for placing an electronic equipment in the cabinet.

Above all, in the cabinet air-conditioning guiding mechanism of the present invention, in addition to using cold and hot communicating pipelines to guide air-conditioning for the cabinet, the front guide modules in corresponding positions could be control to increase (or decrease) the speed of guiding air according to the temperature of the electronic equipments sensed in different position in the cabinet by using the temperature sensing units set in the interior, effect of interior air-conditioning guidance, energy-saving and optimized air-conditioning management could be achieved.

The rising temperature sensed by the temperature sensing units set in the rear frame may be caused by the heat distributed from the operating electronic equipments in the cabinet, thus it could be considered as a cooling requirement. Areas in the cabinet required for cooling could be known specifically by using the temperature saving units set in different positions, and the front guide modules in corresponding positions could be adjusted according to requirements, so that cold air could be fully guided to required area, to achieve the mechanism of air-conditioning guidance in interior of each cabinet according to requirements. Furthermore, in the present invention, information sensed by each temperature sensing unit on the cabinet could be integrated into cooling requirements of each cabinet,

The built-in controller of the cooling apparatus is provided to supply appropriate amount of cold air by calculating according to the cooling requirements of each cabinet, to achieve the effect of saving energy.

For more specific understanding of the above-mentioned objects, purposes and features of the present invention, preferred embodiments of the present invention are described in details as follows:

### BRIEF DESCRIPTION OF THE DRAWINGS

FIG. 1 is a schematic diagram of a conventional air-conditioning plan of an electronic equipment room;
FIG. 2 is a schematic diagram of another conventional air-conditioning plan of an electronic equipment room;
FIG 3 is a schematic diagram of connecting the air-conditioning guide module and the cabinet;
FIG. 4 is a schematic diagram of heat exchange in the cabinet;
FIG. 5 is a schematic diagram of appearance of an example of multiple cabinets;
FIG. 6 is a schematic diagram of appearance of another example of multiple cabinets;
FIG. 7 is a schematic diagram of guiding direction of an embodiment of the cabinet air-conditioning;
FIG. 8 is a schematic diagram of guiding direction of another embodiment of the cabinet air-conditioning;
FIG. 9 is a three-dimensional schematic diagram of a preferred embodiment of the present invention;
FIG. 10 is a schematic diagram of corresponding position of the power supply unit;
FIG. 11 is a configuration diagram of the power distribution unit and the cabling management equipment; and
FIG. 12 is a configuration diagram of the power distribution unit in another view.

### DETAILED DESCRIPTION OF THE INVENTION

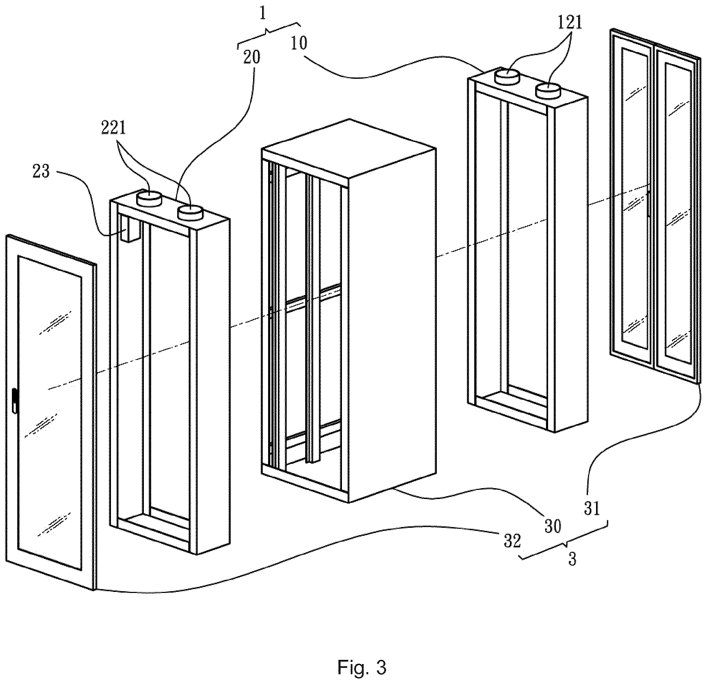

Please refer to FIG. 3 to FIG 5, in the embodiment of the present invention, the air-conditioning guide module 1 set on front and rear sides of the cabinet 3 is provided to form an enclose air-conditioning structure, so as to directly guide air flowing into cabinet 3 for heat exchange. It saves energy wasted outside of the cabinet 3, significantly reduces the needed space of a conventional air-conditioning of an electronic equipment room for arranging cabinets side by side and reserving space of cold and hot channels.

Wherein, the air-conditioning guide module 1 includes a front frame 10 and a rear frame 20 with their shape matching the cabinet 3. The front frame 10 has a front space 11 inside, its one side is provided to connect to a front side of the cabinet 30, and another side is provided to be enclosed by a front board 31 of the cabinet 3; the rear frame 20 has a rear space 21 inside, its one side is provided to connect to a rear side of the cabinet 30, and another side is provided to be enclosed by a rear board 32 of the cabinet 3. In this way, the front space 11 and the rear space 21 are communicated with a placing space 301 inside the cabinet 30 while the front frame 10 and the rear frame 20 are connected to the cabinet 3, so as to form an isolated space.

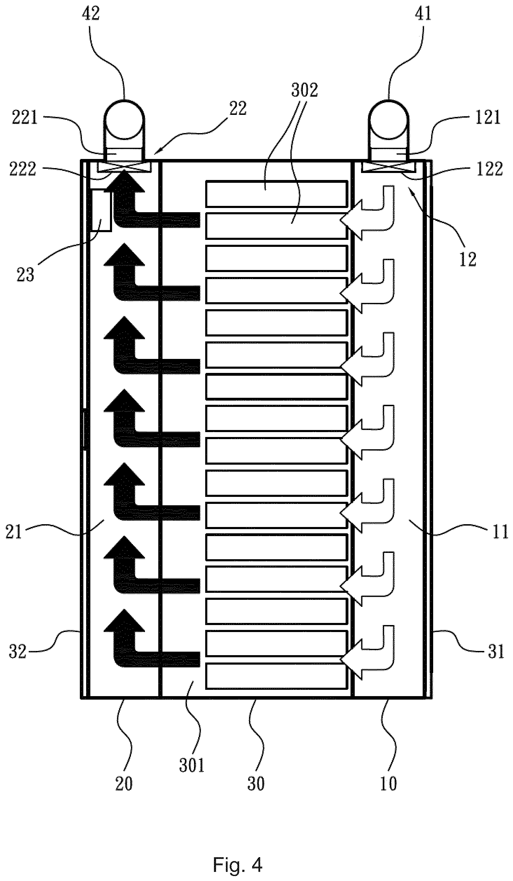

A front guide module 12 is set on the front frame 10, which is provided to guide outside cold air flowing inwards, a rear guide module 22 is set on the rear frame 20, which is provided to guide hot air generated inside flowing outwards, so that cold air guided from the front guide module 12 (shown as white arrows in FIG. 4) is provided for heat exchange with the equipment 302 in the cabinet 30, and hot air may guided out by the rear guide module 22 after heat exchange (shown as black arrows in FIG. 4), to achieve the purpose of directly guiding air-conditioning for the cabinet 3.

In an implemented embodiment, the front guide module 12 includes an inlet 121 and a front air distribution unit 122, the rear guide module 22 includes an outlet 221 and a rear air distribution unit 222, the inlet 121 and the outlet 221 are respectively connected to the cold communicating pipeline 41 and the hot communicating pipeline 42 for supplying the air-conditioning system, and the front air distribution unit 122 and the rear air distribution unit 222 are provided to control flowing direction of cold and hot air.

Furthermore, in the embodiment of the present invention, a temperature sensing unit 23 set in the rear frame 20, which could be set on a position near the rear guide module 22, is provided to sense the rising temperature of the equipment 302 in the cabinet 3 after heat exchange, to effectively adjust the speed of guiding air of the front guide module 12 and the rear guide module 22, to achieve optimized control and energy-saving effect of air-conditioning.

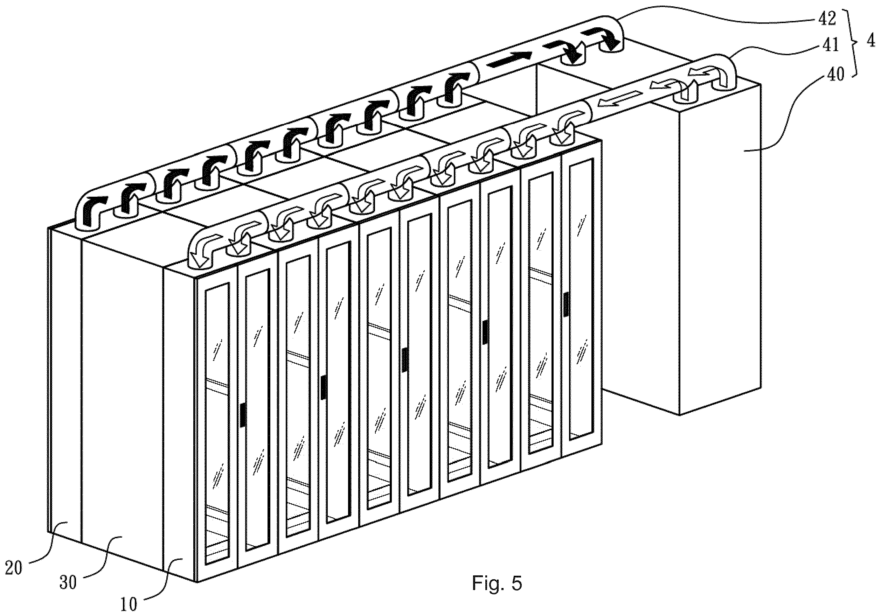

As shown in FIG. 5, which is a schematic diagram of appearance of an example of multiple cabinets, it is applicable to an electronic equipment room, multiple cabinets 3 associated with the above-mentioned air-conditioning guide module 1 are set side by side, and a cooling mechanism 4 is provided to directly guide air-conditioning for each cabinet 3. The cooling mechanism 4 includes a cold communicating pipeline 41, a hot communicating pipeline 42 and a cooling apparatus 40. The cooling apparatus 40 is provided to receive hot air and generate cold air. The cold communicating pipeline 41 respectively connected to the front guide module and the cooling apparatus is provided to supply cold air generated by the cooling apparatus to the front frame. The hot communicating pipeline respectively connected to the rear guide module and the cooling apparatus is provided to supply hot air exhausted from the rear frame to the cooling apparatus. Multiple connecting ends set on the cold communicating pipeline 41 are provided to connect to the inlet 121 of each front guide module 12 and the cooling apparatus 40, to supply cold air generated by the cooling apparatus 40 to each front frame 10. Multiple connecting ends set on the hot communicating pipeline 42 are provided to respectively connect to the outlet 221 of each rear guide module 22 and the cooling apparatus 40, to supply hot air exhausted from the rear frame 20 to the cooling apparatus 40. In the embodiment, the cold communicating pipeline 41, each front guide module 12, the hot communicating pipeline 42 and each rear guide module 22 are all located above each air-conditioning guide module 1, so that cold air could flow downwards naturally after being guided into the front space 11 for conveniently processing heat exchange with the electronic equipment 302 in the cabinet 3, hot air in the rear space 21 could flow upwards naturally after heat exchange, and the rear guide module 22 could guide hot air outwards smoothly on the top.

In practical application of the cabinet air-conditioning guiding mechanism of the present invention, the electronic equipment rooms need not to be re-planned or re-built, the ordinary cabinets 3 also need not to be replaced. It only needs to associate an appropriate air-conditioning guide module 1 with the cabinets 3 and connect the cold communicating pipeline 41 and the hot communicating pipeline 42 of the cooling mechanism 4, the air-conditioning guide system is completed. Furthermore, according to the structure of the cabinet air-conditioning guiding mechanism of the present invention, users could appropriately set the cooling apparatus 40 corresponding to the amount of cabinets 3 by demands, to ensure cooling requirements of each cabinet 3.

In an embodiment, the cold communicating pipeline 41 and the hot communicating pipeline 42, according to requirements (the amount of the cabinets 3), could be composed of several tubes to simply connect to the cooling apparatus 40 and each cabinet 3 to thereby complete the plan of cold/hot channels of the air-conditioning system without re-built the structure of the electronic equipment room, so as to significantly reduce cost of building electronic equipment room.

Besides, according to the structure of cabinet air-conditioning guiding mechanism of the present invention, a corresponding temperature sensing unit 23 is set in the interior of composition of each cabinet 3 and an air-conditioning guide module 1 for controlling the speed of air-conditioning guidance. Thus, when the system is in operation, cold/hot air could be appropriately guide in/out according to interior requirements of each cabinet 3 (namely, the thermal energy generated by electronic equipments 302 in each cabinet 30), so that cold air generated by the cooling apparatus 40 could be certainly supplied to the required cabinet 3 to avoid wasting energy.

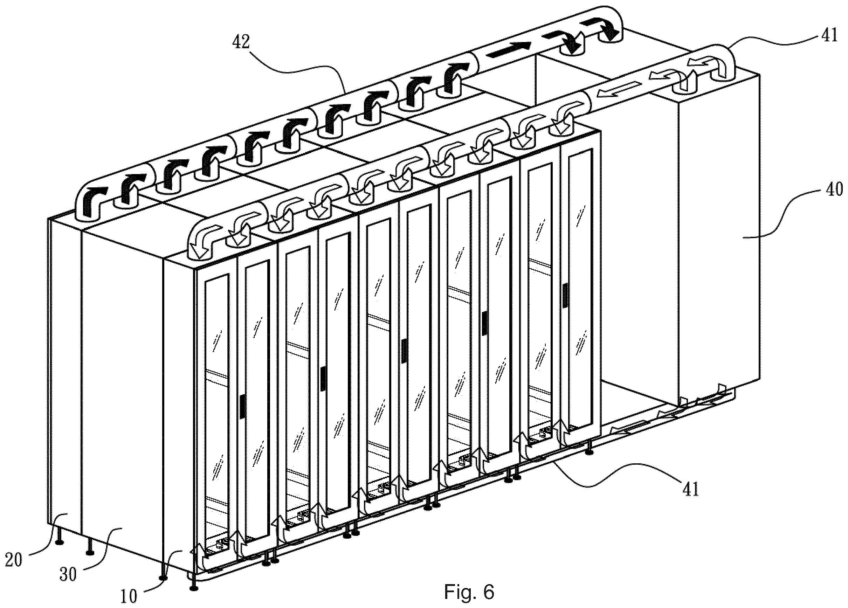

Please refer to FIG. 6 simultaneously, in another embodiment of the present invention, the front guide modules 12 are further set on top and bottom of each front frame 10 of each air-conditioning guide module 1, and two communicating pipelines 41 are respectively connected to the cooling apparatus 40 from top and bottom. The lower cold communicating pipeline 41, as shown in figure, the cabinet 30, the front frame 10 and the rear frame 20 are hold up by using legs, so as to reserve a space for setting; of course, if there is elevated floor setting in the original electronic equipment room, outlet position of the elevated floor could be directly set corresponding to the front guide module 12 on the bottom of the front frame 10 as the cold communicating pipeline 41 of the embodiment, to reduce construction cost. Thus, cold air could be guided into the front frame 10 from top and bottom, so that the electronic equipments 302 in the cabinet 3 could properly contact cold air for heat exchange regardless of height.

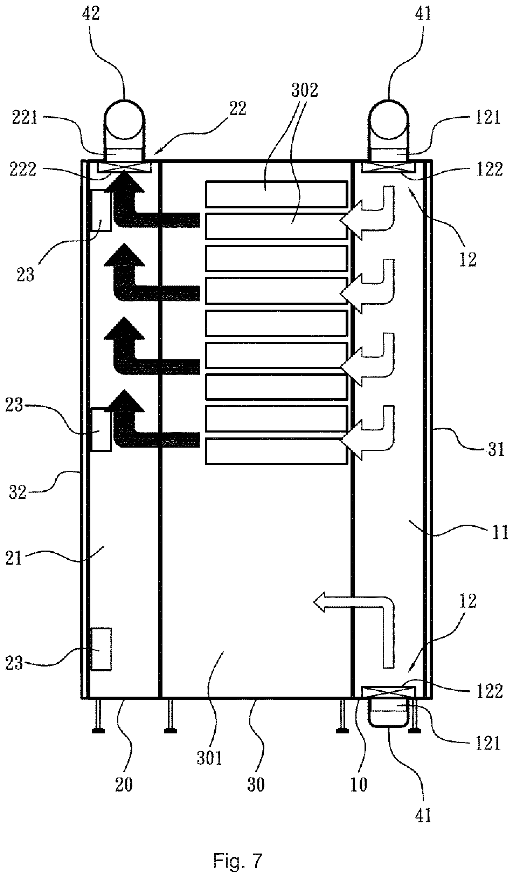

Please refer to FIG. 7 simultaneously, multiple temperature sensing units 23 may further set in each rear frame 20 and located in the positions with different height respectively. In this embodiment, three heights (upper, middle, lower) are illustrated here, so that the corresponding front guide modules 12 may be further controlled for adjusting the speed of guiding air according to the temperature sensed on different height. As shown in figures, if the equipments 302 are mostly placed in upper position in the cabinet 30, the upper temperature sensing unit 23 could sense that the temperature is rising up while operating (shown as wide black arrows in figure, hot air could be sensed by the temperature sensing unit 23 in the relative position), at this time, the front guide module 12 on the top of the front frame 10 could speed up for guiding cold air (shown as wide white arrows in figure). Cold air may supplied appropriately according to cooling requirements of the electronic equipments 302 in the cabinet 30, to improve the efficiency of heat exchange with the electronic equipments 302, to further achieve interior air-conditioning guiding effect. Similarly, if the temperature sensed by the lower temperature sensing unit 23 is rising, the front guide module 12 on the bottom of the front frame 10 could be controlled to speed up for guiding cold air; if the temperature sensed by every temperature sensing unit 23 is rising, the front guide modules 12 on the top and bottom of the front frame 10 could both be controlled to speed up for guiding cold air.

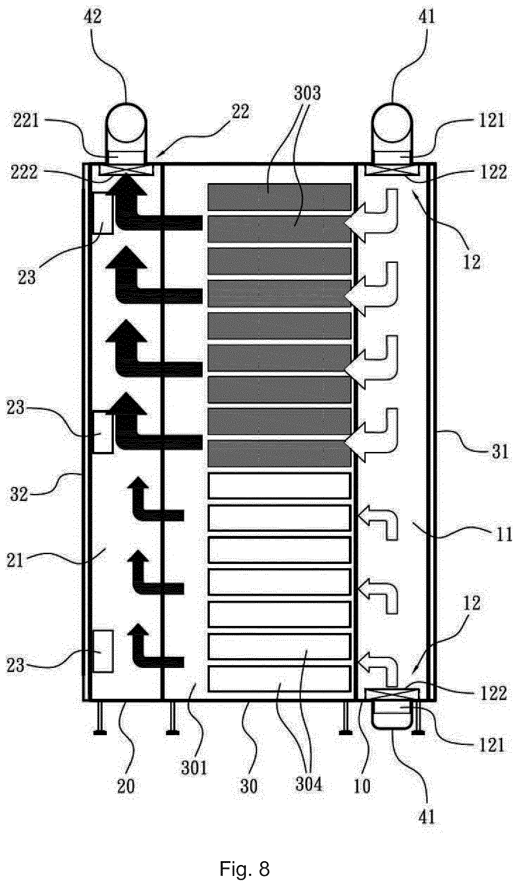

As shown in FIG. 8, it is another embodiment, multiple electronic equipments 303, 304 are set from top to bottom in the cabinet 30, electronic equipments could be divided into electronic equipments 303 in high-speed operation state and electronic equipments 304 in standby or hibernation state according to using or operating state of the electronic equipments.

It is well known that each electronic equipment in the cabinet may be in high-speed operation state or in standby or hibernation state, the specific state varies according to usage requirements. The electronic equipments 303 in high-speed operation state may generate large amount of heat, and the electronic equipments 304 in standby or hibernation state may generate small amount of heat. Thus, if the cabinet air-conditioning is controlled for requirements of high-speed operation state continuously, a large amount of energy wastes under the condition that electronic equipments are not in high-usage state (in standby or hibernation state).

Thus, in FIG. 8, the electronic equipments 303 set in the upper position in the cabinet 30 generates a large amount of heat when in high-speed operation state (shown as wide black arrows in figure), and the electronic equipments 304 set in the lower position generates a small amount of heat when in standby or hibernation state (shown as thinner and lower black arrows in figure). At this time, due to different amount of heat, when the temperature sensed by the upper temperature sensing unit 23 is rising obviously, the front guide module 12 in corresponding position may be driven to speed up for guiding cold air (shown as upper wider white arrows in figure), the efficiency of supplying cold air may be improved for the area with rising temperature in the cabinet 3, and be the same for other area with constant temperature (shown as lower, thinner white arrows in figure), to thereby achieve the effect of interior air-conditioning guiding and energy-saving.

Of course, except the disclosed embodiment, in the cabinet air-conditioning guiding mechanism of the present invention, partial or whole cooling requirements of each cabinet 3 could be determined according to the sensed temperature of different height in the cabinet 3, to thereby guide air-conditioning partially in each cabinet 3, or to converse frequency automatically and adjust output power of the cooling apparatus 40 according to total demands of all of the cabinets 3 and avoid supplying cold air excessively, to achieve the effect of saving energy and control air-conditioning reasonably. In the embodiment, the cooling apparatus 40 and the cabinets 3 are planned with their maximum power, for example, the maximum power of air-conditioning provided by the cooling apparatus 40 is 50k, and each cabinet 3 could consume 10k of air-conditioning power in high-speed operation state, thus the cooling apparatus 40 could be used to correspond five cabinets 3 (as shown in FIG. 5 or FIG. 6) for certainly responding the cooling requirements of the cabinets 3. However, the electronic equipment in the cabinet 3 are not always in high-speed operation state, the cooling requirements of each cabinet 3 could be under 2k if all of the electronic equipments are in standby or hibernation state, 2∼8k if a part of the electronic equipments are in standby state and a part of the electronic equipments are in operation state, 8∼10k if all of the electronic equipments are in operation state, the total cooling requirements of the five cabinets 3 could be under 40k or under 30k, even under 20k at different time. Thus, if the cooling apparatus 40 outputs with maximum power 50k continuously, a large amount of energy wastes. According to the cabinet air-conditioning guiding mechanism of the present invention, the built-in controller of the cooling apparatus 40 is provided to receive cooling requirements from each cabinet 3 (temperature sensing unit 23) and converse frequency automatically and adjust output power according to total requirements of all of the cabinets 3, to achieve the best energy-saving effect and the purpose of controlling air-conditioning in each cabinet in the electronic equipment room.

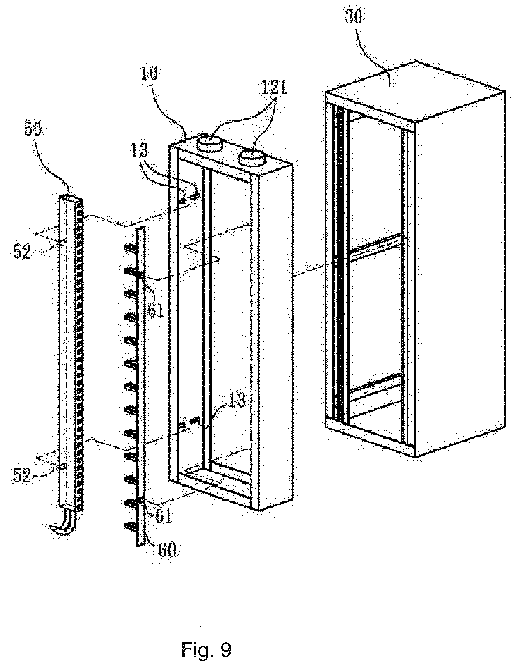

Besides, in the structure disclosed by the present invention, the front space 11 or the rear space 21 are further used to place the required related components of the equipments in the cabinet, as shown in FIG. 9, several sets of engaged portions 13 are set on two sides of the front frame 10, usually it could be used to place the power distribution unit 50 or the cabling management equipment 60, corresponding engaged portions 52 could be set on the back side of the power distribution unit 50 and the cabling management equipment 60 for easily engaging with the engaged portions 13 to place on sides of the front space.

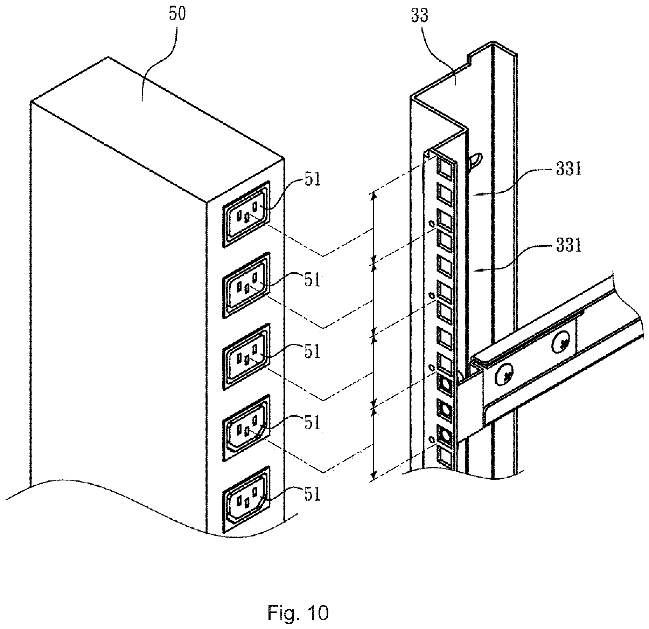

Please refer to FIG 10 simultaneously, brackets 33 for fastening electronic equipments are provided in a common cabinet 30, multiple fastening spacing 331 are set on the brackets 33 (according to the standard of EIA-310-D specified by electronic industries association, height of each fastening spacing 331 is U, 1U=1.75 inches = 44.45 mm), for installing specified electronic equipments. Multiple power supply unit 51 are set on a side of the power distribution unit 50 that each power supply unit 51 is parallel corresponded to each fastening spacing (namely, the height spacing of the power supply units 51 could match U specification), so that the electronic equipments installed in the cabinet 30 could have a applicable power supply unit 51 without the problem of inadequate wiring length or messy wiring.

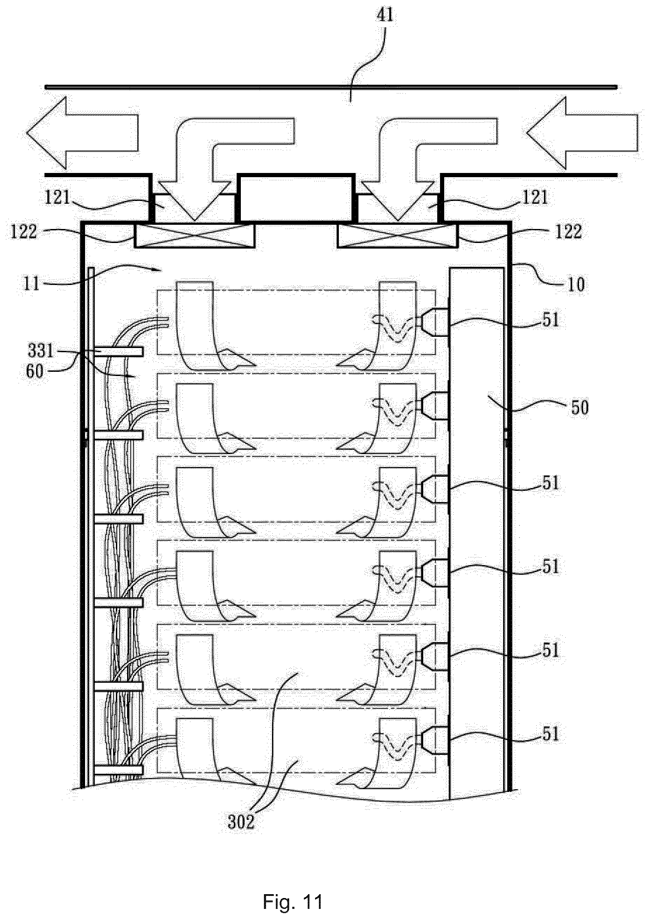

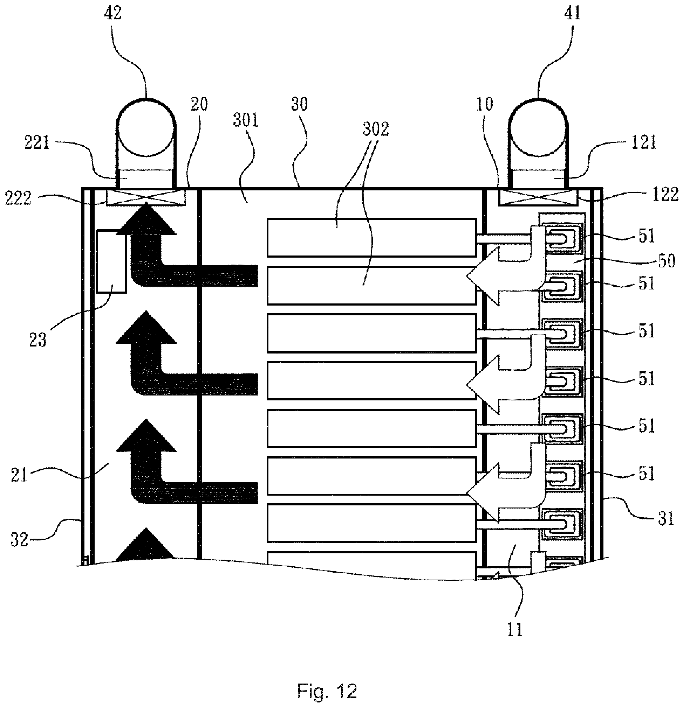

Please refer to FIG. 11 and FIG. 12, by making good use of the front space 11, such as installing the power distribution unit 50 in the front space 11, to solve the problems of limited and crowded space in cabinet 30, the power distribution unit 50 fit U standard could arrange wiring better, or, installing the cabling management equipment 60 in the front space 11, wiring may be arranged by using the front space 11 to smooth air in the cabinet 30 and improve cooling performance in the cabinet 30.

By the air-conditioning guiding mechanism of the present invention, many drawbacks of conventional electronic equipment rooms may be solved, such as: (1) it wastes energy in an opened air-conditioning environment; (2) supplying cold air consistently is hard to improve the problem of overheat partially in the cabinet, but it wastes energy in areas with no needs if the efficacy of supplying cold air is consistently enhanced; (3) cost of building electronic equipment rooms and cabinets is too high, requirement space is too large. By using the present invention, cooling requirements could be controlled and managed for each cabinet, and air-conditioning guiding is provided for partial area in the cabinet, so as to construct an optimized air-conditioning mechanism and energy-saving.

Above all, by applying the air-conditioning guiding system and air-conditioning guide module of the present invention, the purpose of guiding air-conditioning for cabinets and areas in the cabinets with cooling requirements could be certainly achieved, the efficacy of air-conditioning and energy-saving effect are improved, the requirements of large space for planning air-conditioning in a conventional electronic equipment room is also improved and the cost is reduced, thus the present invention is novel and progressive, so that the inventor applies for a patent according to the law.

## Claims

1. A cabinet air-conditioning guiding mechanism, including:
at least a cabinet (3), which includes a placing space (301) inside for placing equipments;
a cooling mechanism, which includes a cold communicating pipeline (41), a hot communicating pipeline (42) and a cooling apparatus (40), wherein the cooling apparatus (40) is provided to receive hot air and generate cold air, wherein the cold communicating pipeline (41) respectively connected to a front part of each cabinet (3) and the cooling apparatus (40)
is provided to supply cold air generated by the cooling apparatus (40) to the front part of each cabinet (3), wherein the hot communicating pipeline (42) respectively connected to a rear part of each cabinet (3) and the cooling apparatus (40) is provided to supply hot air exhausted from the rear part of each cabinet (3) to the cooling apparatus (40);
**characterized in that**
the cabinet air-conditioning guiding mechanism further comprises at least an air-conditioning guide module (1), which includes a front frame (10) and a rear frame (20) with their shape matching the cabinet (3), wherein one front frame (10) and one rear frame (20) is provided for each cabinet (3), one side of the front frame (10)
being connected to a front side of the cabinet (3) and another side thereof being provided to be enclosed by a front board (31) of the cabinet (3) and one side of the rear frame (20) being connected to the rear side of the cabinet (3) and the another side thereof being provided to be enclosed by a rear board (32) of the cabinet (3), wherein the front frame (10) has a front space (11) inside, the rear frame (20) has a rear space (21) inside, the front space (11) and the rear space (21) are communicated with a placing space (301) inside the cabinet (3) but enclosed to the outside while the front frame (10) and the rear frame (20) are connected to the cabinet (3); and, at least a front guide module (12) is set on the front frame (10) for guiding outside cold air flowing inwards, a rear guide module (22) is set on the rear frame (20) for guiding hot air generated inside flowing outwards, to form an unidirectional flow mechanism directly applied to the interior of the cabinet (3); and
wherein the cold communicating pipeline (41), one front guide module (12), the hot communicating pipeline (42) and one rear guide module (22) are located above each air-conditioning guide module (1),
wherein the cold communicating pipeline (41) is respectively connected to the front guide module (12) and the cooling apparatus (40) to supply cold air generated by the cooling apparatus (40) to the front frame (10) and the hot communicating pipeline (42) is respectively connected to the rear guide module (22) and the cooling apparatus (40) to supply hot air exhausted from the rear frame (20) to the cooling apparatus (40).

2. The cabinet air-conditioning guiding mechanism as claimed in claim 1, wherein the front guide module includes an inlet and a front air distribution unit, the rear guide module includes an outlet and a rear air distribution unit.

3. The cabinet air-conditioning guiding mechanism as claimed in claim 2, wherein a temperature sensing unit set inside the rear frame is provided to control the front air distribution unit and the rear air distribution unit for adjusting the speed of guiding air according to the temperature sensed in the interior.

4. The cabinet air-conditioning guiding mechanism as claimed in claim 3, wherein two front guide modules are set on the front guide module, which are placed on top and bottom of the front frame respectively, and the cooling mechanism includes two cold communicating pipelines, which are respectively connected to the two front guide modules and to the cooling apparatus from above or below corresponding positions.

5. The cabinet air-conditioning guiding mechanism as claimed in claim 4, wherein multiple temperature sensing units are set in the rear frame and respectively located in the positions with different height, the corresponding front guide modules are provided to be adjusted respectively according to the temperature sensed on different height in the rear frame.

6. The cabinet air-conditioning guiding mechanism as claimed in claims 3 or 5, wherein the amount of the cabinets and the air-conditioning guide modules is correspondingly a multiple number, multiple connecting ends set on the cold communicating pipeline are provided to connect to the front guide module of each front frame and the cooling apparatus, multiple connecting ends set on the hot communicating pipeline are provided to connect to the rear guide module of each rear frame and the cooling apparatus.

7. The cabinet air-conditioning guiding mechanism as claimed in claims 1, 3 or 5, wherein the front space of the front frame is further used to place at least a power distribution unit or at least a cabling management equipment.

8. The cabinet air-conditioning guiding mechanism as claimed in claims 1, 3 or 5, wherein a power distribution unit is set in the front space, and multiple spaced power supply units are set on a side of the power distribution unit, and each power supply unit is correspondingly to a location reserved for placing an electronic equipment in the cabinet.

## Patentansprüche

1. Schrank - Klimatisierungsführungsmechanismus, der Folgendes enthält:
mindestens einen Schrank (3), der innen einen Platzierungsraum (301) zum Platzieren von Ausrüstung enthält,
einen Kühlmechanismus, der eine kommunizierende Kälteleitung (41), eine kommunizierende Wärmeleitung (42) und eine Kühlvorrichtung (40) enthält, wobei die Kühlvorrichtung (40) bereitgestellt ist, um warme Luft aufzunehmen und kalte Luft zu erzeugen, wobei die kommunizierende Kälteleitung (41), die entsprechend mit einem vorderen Teil jedes Schrankes (3) und der Kühlvorrichtung (40) verbunden ist, bereitgestellt ist, um dem vorderen Teil jedes Schrankes (3) kalte Luft, die durch die Kühlvorrichtung (40) erzeugt wird, zuzuführen, wobei die kommunizierende Wärmeleitung (42), die entsprechend mit einem hinteren Teil jedes Schrankes (3) und der Kühlvorrichtung (40) verbunden ist, bereitgestellt ist, um der Kühlvorrichtung (40) warme Luft, die von dem hinteren Teil jedes Schrankes (3) ausgestoßen wird, zuzuführen,
**dadurch gekennzeichnet, dass**
der Schrank - Klimatisierungsführungsmechanismus ferner mindestens ein Klimatisierungsführungsmodul (1) umfasst, das einen vorderen Rahmen (10) und einen hinteren Rahmen (20) enthält, deren Form mit dem Schrank (3) übereinstimmt, wobei ein vorderer Rahmen (10) und ein hinterer Rahmen (20) für jeden Schrank (3) bereitgestellt sind, wobei eine Seite des vorderen Rahmens (10) mit einer vorderen Seite des Schranks (3) verbunden ist und eine weitere Seite davon bereitgestellt ist, um von einer vorderen Platte (31) des Schrankes (3) umschlossen zu sein, und eine Seite des hinteren Rahmens (20) mit der hinteren Seite des Schranks (3) verbunden ist und die andere Seite davon bereitgestellt ist, um von einer hinteren Platte (32) des Schranks (3) umschlossen zu sein, wobei der vordere Rahmen (10) innen einen vorderen Raum (11) aufweist, der hintere Rahmen (20) innen einen hinteren Raum (21) aufweist, der vordere Raum (11) und der hintere Raum (21) mit einem Platzierungsraum (301) innerhalb des Schranks (3) in Verbindung stehen, aber nach außen umschlossen sind, während der vordere Rahmen (10) und der hintere Rahmen (20) mit dem Schrank (3) verbunden sind,
und dass mindestens ein vorderes Führungsmodul (12) an dem vorderen Rahmen (10) zum Führen von nach innen strömender kalter Außenluft angeordnet ist, ein hinteres Führungsmodul (22) an dem hinteren Rahmen (20) zum Führen von nach außen strömender, innen erzeugter heißer Luft angeordnet ist, um einen unidirektionalen Strömungsmechanismus zu bilden, der direkt auf das Innere des Schranks (3) angewendet wird, und
wobei die kommunizierende Kälteleitung (41), ein vorderes Führungsmodul (12), die kommunizierende Wärmeleitung (42) und ein hinteres Führungsmodul (22) oberhalb jedes Klimatisierungsführungsmoduls (1) angeordnet sind,
wobei die kommunizierende Kälteleitung (41) jeweils mit dem vorderen Führungsmodul (12) und der Kühlvorrichtung (40) verbunden ist, um dem vorderen Rahmen (10) kalte Luft, die durch die Kühlvorrichtung (40) erzeugt wird, zuzuführen, und die kommunizierende Wärmeleitung (42) jeweils mit dem hinteren Führungsmodul (22) und der Kühlvorrichtung (40) verbunden ist, um der Kühlvorrichtung (40) warme Luft, die von dem hinteren Rahmen (20) ausgestoßen wird, zuzuführen.

2. Schrank - Klimatisierungsführungsmechanismus nach Anspruch 1, bei dem das vordere Führungsmodul einen Einlass und eine vordere Luftverteilungseinheit enthält, das hintere Führungsmodul einen Auslass und eine hintere Luftverteilungseinheit enthält.

3. Schrank - Klimatisierungsführungsmechanismus nach Anspruch 2, bei dem eine Temperaturerfassungseinheit, die innerhalb des hinteren Rahmens angeordnet ist, zum Steuern der vorderen Luftverteilungseinheit und der hinteren Luftverteilungseinheit bereitgestellt ist, um die Geschwindigkeit der Führungsluft gemäß der Temperatur einzustellen, die im Inneren erfasst wird.

4. Schrank - Klimatisierungsführungsmechanismus nach Anspruch 3, bei dem zwei vordere Führungsmodule auf dem vorderen Führungsmodul angeordnet sind, die auf der Oberseite bzw. der Unterseite des vorderen Rahmens angeordnet sind, und der Kühlmechanismus zwei kommunizierende Kälteleitungen aufweist, die jeweils mit den zwei vorderen Führungsmodulen und der Kühlvorrichtung von oberhalb oder unterhalb entsprechender Positionen verbunden sind.

5. Schrank - Klimatisierungsführungsmechanismus nach Anspruch 4, bei dem mehrere Temperaturerfassungseinheiten in dem hinteren Rahmen angeordnet sind und jeweils in den Positionen mit unterschiedlicher Höhe platziert sind, wobei die entsprechenden vorderen Führungsmodule bereitgestellt sind, um jeweils gemäß der Temperatur, die auf unterschiedlicher Höhe in dem hinteren Rahmen gemessen wird, eingestellt zu werden.

6. Schrank - Klimatisierungsführungsmechanismus nach Anspruch 3 oder 5, bei dem die Menge der Schränke und der Klimatisierungsführungsmodule einer beliebigen Zahl entsprechen, wobei mehrere Verbindungsenden, die auf der kommunizierenden Kälteleitung angeordnet sind, bereitgestellt sind, um sich mit dem vorderen Führungsmodul jedes vorderen Rahmens und der Kühlvorrichtung zu verbinden, mehrere Verbindungsenden, die auf der kommunizierenden Wärmeleitung angeordnet sind, bereitgestellt sind, um sich mit dem hinteren Führungsmodul jedes hinteren Rahmens und der Kühlvorrichtung zu verbinden.

7. Schrank - Klimatisierungsführungsmechanismus nach Anspruch 1, 3 oder 5, bei dem der vordere Raum des vorderen Rahmens ferner verwendet wird, um mindestens eine Energieverteilungseinheit oder mindestens eine Verkabelungsanordnung zu positionieren.

8. Schrank - Klimatisierungsführungsmechanismus nach Anspruch 1, 3 oder 5, bei dem eine Energieverteilungseinheit in dem vorderen Raum angeordnet ist, und mehrere beabstandete Energieversorgungseinheiten auf einer Seite der Energieverteilungseinheit angeordnet sind, und jede Energieversorgungseinheit einem Standort entspricht, der zum Positionieren einer elektronischen Ausrüstung in dem Schrank vorbehalten ist.

## Revendications

1. Mécanisme de guidage de climatisation d'armoire, comportant:
au moins une armoire (3), qui comporte un espace de placement (301) à l'intérieur pour placer des équipements;
un mécanisme de refroidissement, qui comporte une canalisation de communication de froid (41), une canalisation de communication de chaud (42) et un appareil de refroidissement (40), dans lequel l'appareil de refroidissement (40) est prévu pour recevoir de l'air chaud et générer de l'air froid,
dans lequel la canalisation de communication de froid (41) raccordée respectivement à une partie avant de chaque armoire (3) et à l'appareil de refroidissement (40) est prévue pour fournir de l'air froid généré par l'appareil de refroidissement (40) à la partie avant de chaque armoire (3),
dans lequel la canalisation de communication de chaud (42) raccordée respectivement à une partie arrière de chaque armoire (3) et à l'appareil de refroidissement (40) est prévue pour fournir de l'air chaud évacué depuis la partie arrière de chaque armoire (3) à l'appareil de refroidissement (40);
**caractérisé en ce que**
le mécanisme de guidage de climatisation d'armoire comprend en outre au moins un module de guidage de climatisation (1), qui comporte un châssis avant (10) et un châssis arrière (20), leur forme concordant avec celle de l'armoire (3), dans lequel un châssis avant (10) et un châssis arrière (20) sont prévus pour chaque armoire (3), un côté du châssis avant (10) étant raccordé à un côté avant de l'armoire (3) et un autre côté de celui-ci étant prévu pour être clos par un panneau avant (31) de l'armoire (3) et un côté du châssis arrière (20) étant raccordé au côté arrière de l'armoire (3) et l'autre côté de celui-ci étant prévu pour être clos par un panneau arrière (32) de l'armoire (3),
dans lequel le châssis avant (10) a un espace avant (11) à l'intérieur, le châssis arrière (20) a un espace arrière (21) à l'intérieur, l'espace avant (11) et l'espace arrière (21) communiquent avec un espace de placement (301) à l'intérieur de l'armoire (3) mais sont clos vis-à-vis de l'extérieur tandis que le châssis avant (10) et le châssis arrière (20) sont raccordés à l'armoire (3);
et, au moins un module de guidage avant (12) est installé sur le châssis avant (10) pour guider de l'air froid extérieur s'écoulant vers l'intérieur, un module de guidage arrière (22) est installé sur le châssis arrière (20) pour guider de l'air chaud généré à l'intérieur s'écoulant vers l'extérieur, pour former un mécanisme d'écoulement unidirectionnel appliqué directement à l'intérieur de l'armoire (3); et
dans lequel la canalisation de communication de froid (41), un module de guidage avant (12), la canalisation de communication de chaud (42) et un module de guidage arrière (22) sont situés au-dessus de chaque module de guidage de climatisation (1),
dans lequel la canalisation de communication de froid (41) est raccordée respectivement au module de guidage avant (12) et à l'appareil de refroidissement (40) pour fournir de l'air froid généré par l'appareil de refroidissement (40) au châssis avant (10) et la canalisation de communication de chaud (42) est raccordée respectivement au module de guidage arrière (22) et à l'appareil de refroidissement (40) pour fournir de l'air chaud évacué depuis le châssis arrière (20) à l'appareil de refroidissement (40).

2. Mécanisme de guidage de climatisation d'armoire selon la revendication 1, dans lequel le module de guidage avant comporte un orifice d'entrée et une unité de distribution d'air avant, le module de guidage arrière comporte un orifice de sortie et une unité de distribution d'air arrière.

3. Mécanisme de guidage de climatisation d'armoire selon la revendication 2, dans lequel une unité de détection de température installée à l'intérieur du châssis arrière est prévue pour commander l'unité de distribution d'air avant et l'unité de distribution d'air arrière pour régler la vitesse d'air de guidage selon la température détectée à l'intérieur.

4. Mécanisme de guidage de climatisation d'armoire selon la revendication 3, dans lequel deux modules de guidage avant sont installés sur le module de guidage avant, qui sont placés sur le dessus et le dessous du châssis avant respectivement, et le mécanisme de refroidissement comporte deux canalisations de communication de froid, qui sont raccordées respectivement aux deux modules de guidage avant et à l'appareil de refroidissement par le haut ou le bas de positions correspondantes.

5. Mécanisme de guidage de climatisation d'armoire selon la revendication 4, dans lequel de multiples unités de détection de température sont installées dans le châssis arrière et situées respectivement dans les positions avec une hauteur différente, les modules de guidage avant correspondants sont prévus pour être réglés respectivement selon la température détectée sur une hauteur différente dans le châssis arrière.

6. Mécanisme de guidage de climatisation d'armoire selon les revendications 3 ou 5, dans lequel la quantité des armoires et des modules de guidage de climatisation est de façon correspondante un nombre multiple, de multiples extrémités de raccordement installées sur la canalisation de communication de froid sont prévues pour se raccorder au module de guidage avant de chaque châssis avant et à l'appareil de refroidissement, de multiples extrémités de raccordement installées sur la canalisation de communication de chaud sont prévues pour se connecter au module de guidage arrière de chaque châssis arrière et à l'appareil de refroidissement.

7. Mécanisme de guidage de climatisation d'armoire selon les revendications 1, 3 ou 5, dans lequel l'espace avant du châssis avant est en outre utilisé pour placer au moins une unité de distribution d'électricité ou au moins un équipement de gestion de câblage.

8. Mécanisme de guidage de climatisation d'armoire selon les revendications 1, 3 ou 5, dans lequel une unité de distribution d'électricité est installée dans l'espace avant, et de multiples unités de fourniture d'électricité espacées sont installées sur un côté de l'unité de distribution d'électricité, et chaque unité de fourniture d'électricité se trouve de façon correspondante à un emplacement réservé pour placer un équipement électronique dans l'armoire.
